# FASCICULE DE BREVET EUROPEEN

(11) **EP 3 813 119 B1**
(45) Date de publication et mention de la délivrance du brevet: **26.01.2022**
(21) Numéro de dépôt: 20200803.3
(22) Date de dépôt: 08.10.2020
(51) Int. Cl.: H01L 27/15, H01L 25/075, H01L 25/16, H01L 33/38

(54) **DISPOSITIF D'AFFICHAGE ÉMISSIF À LED**
LED-EMISSIONSANZEIGEVORRICHTUNG
DEVICE FOR LED EMISSIVE DISPLAY

(30) Priorité: 22.10.2019 FR 1911815
(43) Date de publication de la demande: 28.04.2021
(73) Titulaire: Commissariat à l'Energie Atomique et aux Energies Alternatives, 75015 Paris (FR)
(72) Inventeur: SIMON, Julia, 38054 GRENOBLE CEDEX 9 (FR)
(74) Mandataire: Cabinet Beaumont

(56) Documents cités:
- WO-A1-2018/002485
- WO-A1-2019/103568
- WO-A1-2019/180362
- US-A1- 2006 255 343
- US-A1- 2017 288 093
- US-A1- 2018 204 826

## Description

### Domaine technique

La présente description concerne le domaine des dispositifs optoélectroniques. Elle concerne plus particulièrement la réalisation d'un dispositif d'affichage émissif comportant une pluralité de diodes électroluminescentes (LED), par exemple au nitrure de gallium, et un circuit électronique de contrôle de ces LED.

### Technique antérieure

On s'intéresse ici plus particulièrement à la réalisation d'un dispositif d'affichage couleur, c'est-à-dire un dispositif comportant une pluralité de pixels comportant chacun plusieurs LED commandables individuellement, adaptées à émettre respectivement dans des gammes de longueurs d'onde distinctes.

Il serait souhaitable d'améliorer au moins en partie certains aspects des dispositifs d'affichage émissifs à LED couleur connus. Les documents WO2019/103568 et US2017/288093 décrivent des exemples de dispositifs d'affichage émissifs à LED.

### Résumé de l'invention

Pour cela, un mode de réalisation de l'invention prévoit un dispositif d'affichage émissif à LED, comportant une pluralité de pixels comprenant chacun :
- une cellule élémentaire de contrôle formée dans et sur un substrat semiconducteur ;
- une première LED adaptée à émettre dans une première gamme de longueurs d'ondes, disposée sur la face supérieure de la cellule élémentaire de contrôle et ayant une première région de conduction connectée à un premier plot de connexion de la cellule élémentaire de contrôle ; et
- une deuxième LED adaptée à émettre dans une deuxième gamme de longueurs d'ondes, de surface inférieure à celle de la première LED, disposée sur la face supérieure de la première LED en vis-à-vis d'une région centrale de la première LED, et ayant une première région de conduction connectée à un deuxième plot de connexion de la cellule élémentaire de contrôle par l'intermédiaire d'un premier via conducteur traversant la première LED,

dans lequel chaque pixel comprend un mur périphérique métallique entourant entièrement le pixel et s'étendant sur toute la hauteur des LED du pixel,et
dans lequel, dans chaque pixel, chaque LED a une deuxième région de conduction connectée au mur périphérique métallique du pixel, tel que défini dans la revendication 1.

Selon un mode de réalisation, chaque pixel comprend en outre une troisième LED adaptée à émettre dans une troisième gamme de longueurs d'ondes, de surface inférieure à celle de la deuxième LED, disposée sur la face supérieure de la deuxième LED en vis-à-vis d'une région centrale de la deuxième LED, et ayant une première région de conduction connectée à un troisième plot de connexion de la cellule élémentaire de contrôle par l'intermédiaire d'un deuxième via conducteur traversant les première et deuxième LED.

Selon l'invention, chaque pixel comprend un mur périphérique métallique entourant entièrement le pixel et s'étendant sur toute la hauteur des LED du pixel.

Selon un mode de réalisation, le mur périphérique est réfléchissant pour la lumière émise par chaque LED, et forme un miroir guidant la lumière émise par chaque LED.

Selon l'invention, dans chaque pixel, chaque LED a une deuxième région de conduction connectée au mur périphérique métallique du pixel.

Selon un mode de réalisation, chaque LED comprend un empilement comportant, dans l'ordre en partant de la face supérieure du substrat semiconducteur, une première couche semiconductrice dopée d'un premier type de conductivité, formant la première région de conduction de la LED, une couche active, et une deuxième couche semiconductrice dopée du second type de conductivité, formant la deuxième région de conduction de la LED.

Selon un mode de réalisation, dans chaque pixel, chaque LED est connectée au mur périphérique métallique du pixel par un flanc de sa deuxième couche semiconductrice.

Selon un mode de réalisation, dans chaque pixel, chaque LED a sa première couche semiconductrice en contact, par sa face inférieure, avec une couche métallique s'étendant sous toute la surface de la LED.

Selon un mode de réalisation, pour chaque LED, la couche métallique en contact avec la face inférieure de la première couche semiconductrice de la LED est une couche réfléchissante formant un miroir guidant la lumière émise par chaque LED.

Selon un mode de réalisation, les premières et deuxièmes régions de conduction des LED sont respectivement des régions d'anode et des régions de cathode.

Selon un mode de réalisation, chaque pixel comprend une région diélectrique transparente recouvrant une partie périphérique de la première LED non recouverte par la deuxième LED.

Selon un mode de réalisation, la première LED présente, dans une partie périphérique de la première LED non recouverte par la deuxième LED, des nanostructurations adaptée à favoriser l'extraction de la lumière émise par la première LED.

Un autre mode de réalisation selon l'invention, tel que défini par la revendication 11, prévoit un procédé de fabrication d'un dispositif d'affichage émissif à LED tel que défini ci-dessus, comportant les étapes successives suivantes :
- rapporter un premier empilement actif de LED sur la face supérieure d'un circuit intégré de contrôle comprenant les cellules élémentaires de contrôle du dispositif, de façon que le premier empilement actif de LED s'étende de façon continue sur toute la surface du circuit intégré de contrôle ;
- former dans le premier empilement actif de LED des tranchées délimitant latéralement les premières LED du dispositif ;
- rapporter un deuxième empilement actif de LED sur la face supérieure de l'ensemble comportant le circuit intégré et les premières LED, de façon que le deuxième empilement actif de LED s'étende de façon continue sur toute la surface du circuit intégré de contrôle ; et
- former dans le deuxième empilement actif de LED des tranchées délimitant latéralement les deuxièmes LED du dispositif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessus d'un pixel d'un dispositif d'affichage émissif à LED selon un mode de réalisation ;
la figure 1B est une vue en coupe du pixel de la figure 1A ; et
les figures 2A à 2R sont des vues en coupe ou de dessus illustrant des étapes successives d'un exemple d'un procédé de fabrication d'un dispositif d'affichage émissif à LED selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation d'un circuit électronique de contrôle des dispositifs d'affichage décrits n'a pas été détaillée, la réalisation d'un tel circuit étant à la portée de l'homme du métier à partir des éléments de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

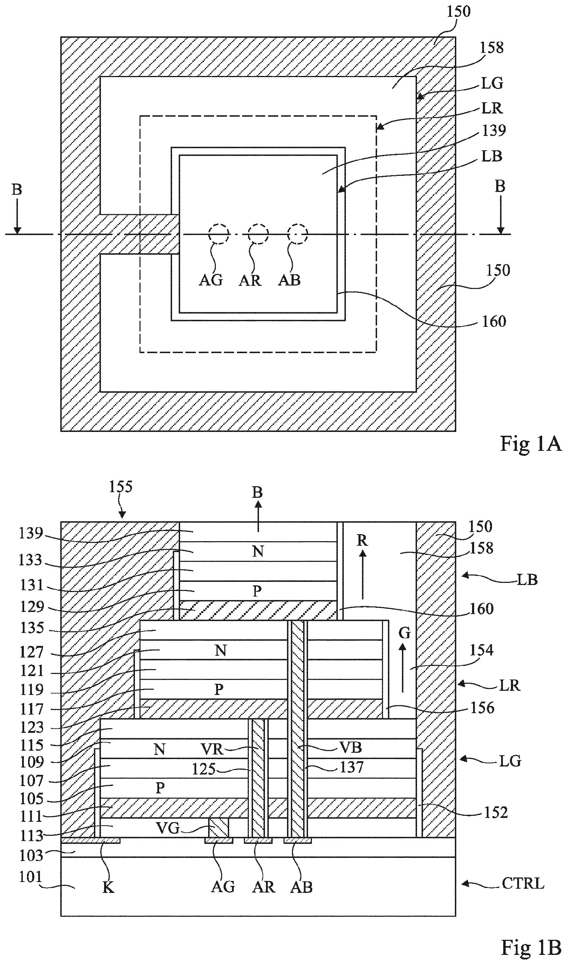

Les figures 1A et 1B illustrent de façon schématique et partielle un exemple d'un dispositif d'affichage émissif à LED couleur selon un mode de réalisation. Sur les figures 1A et 1B, un unique pixel du dispositif a été représenté. En pratique, le dispositif peut comporter une pluralité de pixels identiques ou similaires, commandables individuellement. La figure 1A est une vue de dessus du dispositif, et la figure 1B est une vue en coupe selon le plan B-B de la figure 1A.

Chaque pixel du dispositif des figures 1A et 1B comprend trois LED LG, LR et LB commandables individuellement, adaptées à émettre respectivement dans trois gammes de longueurs d'ondes distinctes. A titre d'exemple, la LED LG est adaptée à émettre majoritairement de la lumière verte, la LED LR est adaptée à émettre majoritairement de la lumière rouge, et la LED LB est adaptée à émettre majoritairement de la lumière bleue. Chaque pixel comprend en outre une cellule élémentaire de contrôle CTRL intégrée dans et sur un substrat semiconducteur 101, comportant trois plots métalliques de connexion AG, AR et AB connectés respectivement à l'anode de la LED LG, à l'anode de la LED LR, et à l'anode de la LED LB. Dans cet exemple, chaque cellule élémentaire de contrôle CTRL comprend en outre un plot métallique de connexion K connecté à la cathode de la LED LG, à la cathode de la LED LR, et à la cathode de la LED LB. La cellule CTRL permet de commander individuellement les LED LG, LR et LB via les plots de connexion AG, AR et AB, étant entendu que les différents pixels du dispositif d'affichage peuvent être commandés individuellement via leurs cellules élémentaires de contrôle CTRL respectives.

Chaque cellule élémentaire de contrôle peut comprendre un ou plusieurs transistors (non détaillés sur les figures), par exemple des transistors MOS. Sur la figure 1B, on a représenté de façon schématique un empilement 103 de couches diélectriques et conductrices revêtant la face supérieure du substrat 101. L'empilement 103 comprend notamment les plots métalliques de connexion K, AG, AR et AB de chaque cellule CTRL, et peut en outre comprendre des éléments métalliques d'interconnexion (non détaillés sur les figures) des différents composants des cellules élémentaires de contrôle CTRL. La face supérieure de l'empilement 103 constitue la face supérieure des cellules de contrôle CTRL. Dans cet exemple, les plots métalliques de connexion K, AG, AR et AB de chaque cellule de contrôle CTRL affleurent au niveau de la face supérieure de l'empilement 103.

La LED LG comprend un empilement comportant, dans l'ordre à partir de la surface supérieure de la cellule élémentaire de contrôle CTRL, une couche semiconductrice 105 dopée de type P, définissant l'anode de la LED LG, une couche active 107, et une couche semiconductrice 109 dopée de type N, définissant la cathode de la LED LG. En vue de dessus, les couches 105, 107 et 109 ont par exemple toutes sensiblement la même surface, définissant la surface de la LED LG. Chaque pixel comprend en outre, sous la LED LG, une couche métallique 111 en contact, par sa face supérieure, avec la face inférieure de la couche d'anode 105 de la LED. La couche métallique 111 s'étend par exemple sous sensiblement toute la surface inférieure de la LED LG. Chaque pixel comprend en outre une couche diélectrique 113 faisant interface entre la cellule élémentaire de contrôle CTRL et la couche métallique 111. La couche 113 est par exemple en contact, par sa face inférieure, avec la face supérieure de la cellule élémentaire de contrôle CTRL, et, par sa face supérieure, avec la face inférieure de la couche métallique 111. Chaque pixel comprend en outre un via métallique VG traversant la couche 113 et connectant la couche métallique 111 au plot de connexion AG de la cellule élémentaire de contrôle CTRL. Chaque pixel comprend en outre une couche diélectrique de protection 115 revêtant la face supérieure de la couche de cathode 109 de la LED LG. La couche 115 est par exemple en contact avec la face supérieure de la couche de cathode 109, sur sensiblement toute la surface supérieure de la LED LG.

La LED LR comprend un empilement comportant, dans l'ordre à partir de la surface supérieure de la couche diélectrique 115, une couche semiconductrice 117 dopée de type P, définissant l'anode de la LED LR, une couche active 119, et une couche semiconductrice 121 dopée de type N, définissant la cathode de la LED LR. En vue de dessus, les couches 117, 119 et 121 ont par exemple toutes sensiblement la même surface, définissant la surface de la LED LR. En vue de dessus, la surface de la LED LR est inférieure à la surface de la LED LG et est disposée en vis-à-vis d'une région centrale de la LED LG. Chaque pixel du dispositif comprend en outre, sous la LED LR, une couche métallique 123 en contact, par sa face supérieure, avec la face inférieure de la couche d'anode 117 de la LED LR. La couche métallique 123 est par exemple en contact, par sa face inférieure, avec la face supérieure de la couche diélectrique 115. La couche métallique 123 occupe par exemple sensiblement la même surface que la LED LR. Autrement dit, la région périphérique de la LED LG non revêtue par la LED LR n'est pas non plus revêtue par la couche métallique 123. Chaque pixel comprend en outre un via métallique VR traversant les couches 113, 111, 105, 107, 109 et 115 et connectant la couche métallique 123 au plot de connexion AR de la cellule élémentaire de contrôle CTRL du pixel. Le via métallique VR est isolé latéralement, notamment des couches 111, 105, 107 et 109, par une couche diélectrique 125. Chaque pixel du dispositif d'affichage comprend en outre une couche diélectrique de protection 127 revêtant la face supérieure de la couche de cathode 121 de la LED LR. La couche 127 est par exemple en contact avec la face supérieure de la couche de cathode 121, sur sensiblement toute la surface supérieure de la LED LR.

La LED LB comprend un empilement comportant, dans l'ordre à partir de la surface supérieure de la couche diélectrique 127, une couche semiconductrice 129 dopée de type P, définissant l'anode de la LED LB, une couche active 131, et une couche semiconductrice 133 dopée de type N, définissant la cathode de la LED LB. En vue de dessus, les couches 129, 131 et 133 ont par exemple toutes sensiblement la même surface, définissant la surface de la LED LB. En vue de dessus, la surface de la LED LB est inférieure à la surface de la LED LR et est disposée en vis-à-vis d'une région centrale de la LED LR. Chaque pixel du dispositif comprend en outre, sous la LED LB, une couche métallique 135 en contact, par sa face supérieure, avec la face inférieure de la couche d'anode 129 de la LED. La couche métallique 135 est par exemple en contact, par sa face inférieure, avec la face supérieure de la couche diélectrique 127. La couche métallique 135 occupe par exemple sensiblement la même surface que la LED LB. Autrement dit, la région périphérique de la LED LR non revêtue par la LED LB n'est pas non plus revêtue par la couche métallique 135. Chaque pixel comprend en outre un via métallique VB traversant les couche 113, 111, 105, 107, 109, 115, 123, 117, 119, 121 et 127, et connectant la couche métallique 135 au plot de connexion AB de la cellule élémentaire de contrôle CTRL. Le via métallique VB est isolé latéralement, notamment des couches 111, 105, 107, 109, 123, 117, 119 et 121, par une couche diélectrique 137. Chaque pixel du dispositif d'affichage peut en outre comprendre une couche diélectrique de protection 139 revêtant la face supérieure de la couche de cathode 133 de la LED LB. La couche 139 est par exemple en contact avec la face supérieure de la couche de cathode 133, sur sensiblement toute la surface supérieure de la LED LB.

Les couches 105, 107, 109, 117, 119, 121, 129, 131 et 133 sont par exemple des couches à base de matériaux semiconducteurs III-V, par exemple à base de nitrure de gallium, ou à base d'AlInGaP (phosphure de gallium-indiumaluminium). Chacune des couches actives 107, 119 et 129 peut être constituée d'une alternance de couches de matériaux distincts définissant des puits quantiques multiples. Les LED LG, LR et LB peuvent avoir des couches d'anode respectives et/ou des couches actives respectives et/ou des couches de cathode respectives, de compositions différentes. En particulier, la longueur d'onde d'émission principale de chaque LED dépend notamment de la composition de sa couche active.

Chaque pixel du dispositif d'affichage des figures 1A et 1B comprend en outre un mur métallique périphérique 150 entourant entièrement, en vue de dessus, les LED LG, LR et LB du pixel, et séparant latéralement les LED LG, LR et LB du pixel des LED LG, LR et LB des autres pixels du dispositif. D'après l'invention,et tel que représenté, le mur métallique 150 s'étend verticalement depuis la face supérieure de la cellule élémentaire de contrôle CTRL du pixel, c'est-à-dire depuis la face supérieure de l'empilement d'interconnexion 103, jusqu'à la face supérieure de la couche diélectrique de protection 139 surmontant la LED LB.

Le mur périphérique 150 est séparé latéralement de la LED inférieure LG du pixel par une mince couche diélectrique 152 revêtant, dans cet exemple, toute la surface des flancs des couches 113, 111, 105 et 107. En vue de dessus, la couche diélectrique 152 a la forme d'un anneau fermé. Toutefois, sur au moins une partie de la périphérie de la LED LG, le flanc de la couche 109 n'est pas revêtu par la couche diélectrique 152. A cet endroit, le mur périphérique 150 est en contact avec le flanc de la couche de cathode 109 de la LED LG.

Le mur périphérique 150 est en outre séparé latéralement de la LED intermédiaire LR du pixel par une région diélectrique 154 de largeur sensiblement égale à la largeur de la région périphérique de la LED LG non revêtue par la LED LR. La région 154 revêt les flancs des couches 123, 117, 119, 121 et 127. Dans cet exemple, une mince couche diélectrique 156 sépare latéralement les flancs des couches 123, 117, 119, 121 et 127 de la région 154. La région 154 est interrompue sur une partie de la périphérie de la LED LR. Autrement dit, en vue de dessus, la région 154 a la forme d'un anneau ouvert. La couche 156 revêt quant à elle toute la surface des flancs des couches 123, 117, 119, 121 et 127. Autrement dit, en vue de dessus, la couche 156 a la forme d'un anneau fermé. Toutefois, au niveau de la zone d'interruption de la région diélectrique 154, le flanc des couches 121 et 127 n'est pas revêtu par la couche 156. A cet endroit, le mur périphérique métallique 150 présente une excroissance s'étendant, en vue de dessus, vers l'intérieur du pixel et venant en contact avec le flanc de la couche de cathode 121 de la LED LR et avec le flanc de la couche diélectrique de protection 127.

Le mur périphérique 150 est par ailleurs séparé latéralement de la LED supérieure LB du pixel par une région diélectrique 158 de largeur sensiblement égale à la somme de la largeur de la région périphérique de la LED LG non revêtue par la LED LR et de la largeur de la région périphérique de la LED LR non revêtue par la LED LB. La région 158 revêt les flancs des couches 135, 129, 131, 133 et 139. De plus, dans cet exemple, une mince couche diélectrique 160 sépare latéralement les flancs des couches 135, 129, 131, 133 et 139 de la région 158. La région 158 est interrompue sur une partie de la périphérie de la LED LB. Autrement dit, en vue de dessus, la région 158 a la forme d'un anneau ouvert. La zone d'interruption de la région 158 est par exemple superposée à la zone d'interruption de la région 154. La couche 160 revêt quant à elle toute la surface des flancs des couches 135, 129, 131, 133 et 139. Autrement dit, en vue de dessus, la couche 160 a la forme d'un anneau fermé. Toutefois, au niveau de la zone d'interruption de la région diélectrique 158, le flanc de la couche 133 et le flanc de la couche 139 ne sont pas revêtu par la couche 160. A cet endroit, le mur périphérique métallique 150 présente une excroissance s'étendant, en vue de dessus, vers l'intérieur du pixel et venant en contact avec le flanc de la couche de cathode 133 de la LED LB et avec le flanc de la couche diélectrique 139.

Ainsi, le mur métallique 150 est connecté électriquement aux régions de cathode des LED LG, LR et LB du pixel. Dans cet exemple, le mur métallique 150 est en contact, par sa face inférieure, avec le plot de connexion de cathode K de la cellule élémentaire de contrôle CTRL du pixel.

Le fonctionnement du pixel des figures 1A et 1B est le suivant.

Lorsque la LED inférieure LG est commandée, via le plot de connexion AG, pour émettre de la lumière, la lumière émise se réfléchit, verticalement, sur la couche métallique 123 et/ou sur la couche métallique 111, et, latéralement, sur le mur métallique 150. On considère ici la couche diélectrique 115 et les régions diélectriques périphériques 154 et 158 comme étant sensiblement transparentes pour la lumière émise par la LED LG. Ainsi, la lumière G émise par la LED LG est extraite du pixel par sa face supérieure, principalement selon une direction verticale, dans une région périphérique annulaire correspondant sensiblement à la région périphérique de la LED LG non revêtue par la LED LR.

Lorsque la LED intermédiaire LR est commandée, via le plot de connexion AR, la lumière émise se réfléchit, verticalement, sur la couche métallique 135 et/ou sur la couche métallique 123, et, latéralement, sur le mur métallique 150. On considère ici la couche diélectrique 127 et la région diélectrique périphérique 158 comme étant sensiblement transparentes pour la lumière émise par la LED LR. Ainsi, la lumière R émise par la LED LR est extraite du pixel par sa face supérieure, principalement selon une direction verticale, dans une région périphérique annulaire correspondant sensiblement à la région périphérique de la LED LR non revêtue par la LED LB.

Lorsque la LED supérieure LB est commandée, via le plot de connexion AB, pour émettre de la lumière, la lumière B émise par la LED LB est extraite du pixel par sa face supérieure, principalement selon une direction verticale, dans une région centrale du pixel s'étendant sur sensiblement toute la surface de la LED LB. On considère ici la couche diélectrique supérieure 139 comme étant sensiblement transparente pour la lumière émise par la LED LB.

On notera que l'ordre d'empilement des LED peut être choisi en fonction des performances attendues par couleur. En particulier, la surface de la LED inférieure étant plus importante que celle de la LED intermédiaire, et la surface de la LED intermédiaire étant elle-même plus importante que la surface de la LED supérieure, on pourra choisir, comme LED inférieure, celle dont l'efficacité est la moins élevée, et, comme LED supérieure, celle dont l'efficacité est la plus élevée.

Bien que non représentées sur les figures 1A et 1B, chacune des couches de cathode 109, 121 et 133 des LED LG, LR et LB peut comporter, du côté de sa face supérieure, des nanostructurations, formant par exemple des cristaux photoniques, permettant de favoriser l'extraction lumineuse et la directivité d'émission de la LED, et donc d'améliorer son efficacité. De préférence, les nanostructurations sont formées uniquement en vis-à-vis des régions d'extraction lumineuse de chaque LED. Autrement dit, dans un mode de réalisation préféré, la couche 109 présente des nanostructurations uniquement sur la portion périphérique de sa face supérieure non revêtue par la LED LR ou par le mur métallique 150, la couche 121 présente des nanostructurations uniquement sur la portion périphérique de sa face supérieure non revêtue par la LED LB ou par le mur métallique 150, et la couche 133 présente des nanostructurations sur sensiblement toute sa face supérieure. Les modes de réalisation décrits ne se limitent toutefois pas à ce cas particulier.

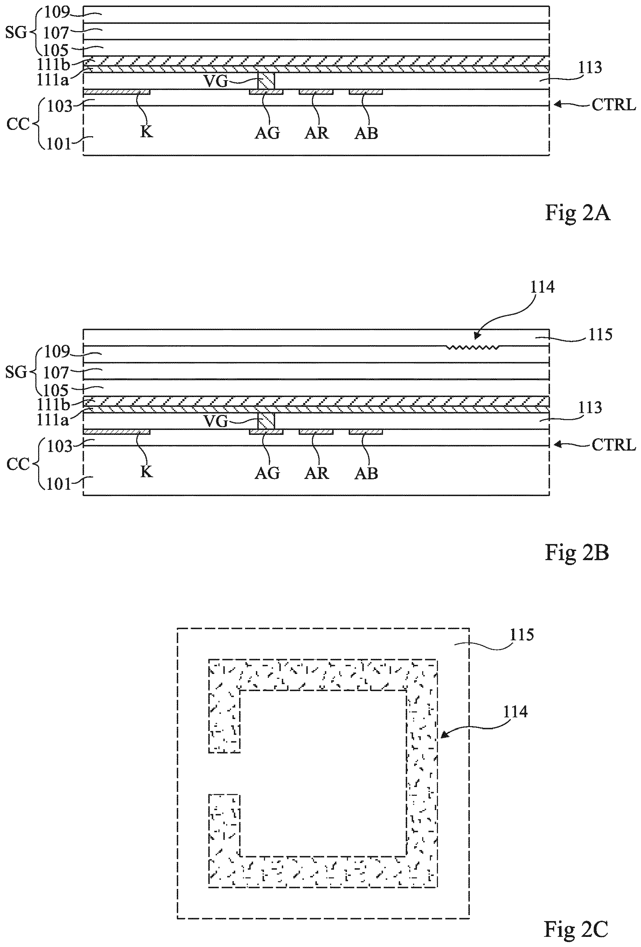

Les figures 2A à 2R sont des vues en coupe ou de dessus illustrant des étapes successives d'un exemple d'un procédé de fabrication d'un dispositif d'affichage émissif à LED du type décrit en relation avec les figures 1A et 1B.

Sur les figures 2A à 2R, la réalisation d'un unique pixel du dispositif a été représentée, étant entendu que, en pratique, le dispositif d'affichage peut comporter une pluralité de pixels identiques ou similaires réalisés simultanément et de façon monolithique dans et sur un même substrat semiconducteur.

La figure 2A est une vue en coupe illustrant une étape de report d'un premier empilement actif de LED SG sur la face supérieure d'un circuit intégré de contrôle CC préalablement formé dans et sur un substrat semiconducteur 101, par exemple en silicium. Le circuit de contrôle CC comprend, pour chaque pixel du dispositif d'affichage, une cellule élémentaire de contrôle CTRL des LED LG, LR et LB du pixel. En vue de dessus (non représentée), les cellules élémentaires de contrôle CTRL sont par exemple disposées en matrice selon des rangées et des colonnes. Le circuit de contrôle CC est par exemple réalisé en technologie CMOS (de l'anglais "Complementary Metal Oxide Semiconductor" - métal oxyde semiconducteur complémentaire).

L'empilement SG est constitué par les couches 105, 107 et 109 qui, à ce stade, s'étendent chacune de façon continue sur toute la surface supérieure du circuit de contrôle. L'empilement SG est par exemple formé par épitaxie sur une face d'un substrat de croissance, non représenté, par exemple un substrat en saphir. Plus particulièrement, la couche 109, puis la couche 107, puis la couche 105 peuvent être successivement déposées sur le substrat de croissance. Une ou plusieurs couches tampon, non représentées, peuvent faire interface entre le substrat de croissance et la couche 109. La couche 107 est par exemple déposée sur et en contact avec la face de la couche 109 opposée au substrat de croissance. La couche 105 peut être déposée sur et en contact avec la face de la couche 107 opposée au substrat de croissance.

Préalablement au report de l'empilement SG sur le circuit de contrôle CC, la couche diélectrique 113 et les vias métalliques VG peuvent être formés sur la face supérieure du circuit de contrôle CC. Une couche métallique 111a peut ensuite être déposée sur et en contact avec la face supérieure de la couche diélectrique 113 et des vias métalliques VG. La couche 111a s'étend par exemple de façon continue sur toute la surface supérieure du circuit de contrôle CC. De plus, une couche métallique 111b peut être déposée sur et en contact avec la face de la couche 105 opposée au substrat de croissance de l'empilement SG. La couche 111b s'étend par exemple de façon continue sur toute la surface de l'empilement SG opposée au substrat de croissance.

L'ensemble comprenant le substrat de croissance, l'empilement SG et la couche métallique 111b peut ensuite être reporté sur l'ensemble comportant le circuit de contrôle CC, la couche diélectrique 113, les vias métalliques VG, et la couche métallique 111a, par collage direct (ou par thermocompression) de la face de la couche métallique 111b opposée au substrat de croissance sur la face de la couche métallique 111a opposée au substrat semiconducteur 101.

Le substrat de croissance de l'empilement SG peut ensuite être retiré, par exemple par un procédé de type LLO (de l'anglais "Laser Lift Off" - décollage par laser). La ou les éventuelles couches tampon présentes sur la face supérieure de la couche 109 peuvent en outre être retirées, par exemple par CMP (de l'anglais "Chemical Mechanical Polishing" - polissage mécano-chimique), ou encore par RIE (de l'anglais "Reactive Ion Etching" - gravure ionique réactive) ou par IBE (de l'anglais "Ion Beam Etching" - gravure par faisceau ionique), de façon à libérer l'accès à la face supérieure de la couche 109.

Dans cet exemple, les couches métalliques 111a et 111b correspondent, une fois assemblées, à la couche 111 de la structure des figures 1A et 1B.

Les figures 2B et 2C sont respectivement une vue en coupe et une vue de dessus illustrant une étape de formation, sur la face supérieure de la couche 109, de nanostructurations 114, formant par exemple des cristaux photoniques, visant à favoriser l'extraction des photons générés par les LED LG. A titre d'exemple, les nanostructurations sont formés uniquement dans la partie périphérique de chaque LED LG destinée à être revêtue par la région diélectrique 154 du pixel correspondant. A titre de variante, les nanostructurations peuvent être formés sur toute la surface supérieure de la couche 109, à l'exception des régions destinées à être gravées lors d'étapes ultérieures du procédé.

Les figures 2B et 2C illustrent en outre une étape ultérieure de dépôt d'une couche diélectrique de protection 115, par exemple une couche d'oxyde de silicium ou de nitrure de silicium, sur et en contact avec la face supérieure de la couche 109. La couche 115 s'étend par exemple de façon continue sur toute la surface supérieure de la couche 109. La couche 115 sert notamment de couche d'encapsulation des nanostructurations, et peut en outre servir de couche de masque dur pour la gravure de l'empilement SG.

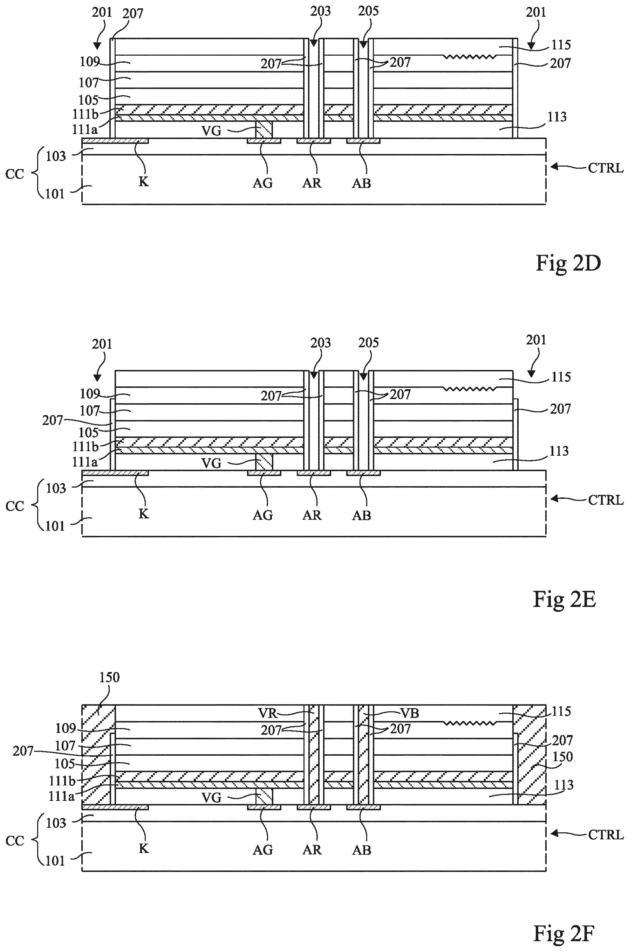

La figure 2D illustre une étape de lithographie et gravure de l'empilement actif de LED SG. Lors de cette étape, des tranchées 201 sont formées à partir de la face supérieure de la structure. Les tranchées 201 délimitent latéralement les LED LG des différents pixels du dispositif. Dans l'exemple représenté, les tranchées 201 s'étendent verticalement depuis la face supérieure de la couche diélectrique 115 jusqu'à la face supérieure du circuit de contrôle CC. A l'issue de cette étape, chaque LED LG a la forme d'un îlot ou mésa entièrement séparé des LED LG voisines par les tranchées 201. En vue de dessus, les tranchées 201 forment par exemple une grille continue délimitant les pixels du dispositif. Les tranchées 201 sont destinées à recevoir les murs métalliques périphériques 150 des pixels.

La figure 2D illustre en outre la formation, dans chaque pixel du dispositif, d'une ouverture traversante 203 s'étendant verticalement depuis la face supérieure de la couche diélectrique 115 jusqu'à la face supérieure du circuit de contrôle CC, en vis-à-vis du plot de connexion d'anode AR de la cellule élémentaire de contrôle CTRL du pixel, et d'une ouverture traversante 205 s'étendant verticalement depuis la face supérieure de la couche diélectrique 115 jusqu'à la face supérieure du circuit de contrôle CC, en vis-à-vis du plot de connexion d'anode AB de la cellule élémentaire de contrôle CTRL du pixel. Les ouvertures 203 et 205 sont destinés à recevoir respectivement les vias métalliques VR et VB du pixel. Les ouvertures 203 et 205 sont par exemple formées en même temps que les tranchées 201.

La figure 2D illustre de plus une étape de dépôt d'une mince couche diélectrique 207 sur les parois latérales des tranchées 201 et des ouvertures 203 et 205. L'épaisseur de la couche 207 est par exemple inférieure à 200 nm, par exemple de l'ordre de 50 nm. La couche 207 peut être une couche d'oxyde, par exemple une couche d'alumine (Al₂0₃). La couche 207 peut être déposé par un procédé de dépôt conforme, par exemple par dépôt ALD (de l'anglais "Atomic Layer Deposition" - dépôt en couches monoatomiques successives). A titre d'exemple, la couche 207 est d'abord déposée de façon continue sur toute la surface de la structure, puis retirée au fond des tranchées 201 et des ouvertures 203 et 207 et sur la face supérieure de la couche diélectrique 115 par un procédé de gravure anisotrope verticale. La couche 207 de la figure 2D correspond aux régions diélectriques 152 et 125 de la figure 1B, ainsi qu'à une partie inférieure de la région diélectrique 137 de la figure 1B.

La figure 2E est une vue en coupe illustrant une étape de retrait d'une partie supérieure de la couche diélectrique 207 sur les parois latérales des tranchées 201. Plus particulièrement, la couche 207 est retirée, dans les tranchées 201, sur les flancs de la couche diélectrique 115 et sur une partie supérieure des flancs de la couche de cathode 109 des LED LG, de façon à permettre la reprise d'un contact électrique sur la couche 109, via les murs métalliques 150. La couche 207 est en revanche conservée sur les flancs de la couche active 107 et des couches sous-jacentes, de façon à isoler électriquement les couches 105, 107 et 111 des murs métalliques 150. La couche 207 est de plus conservée sur toute la hauteur des ouvertures 203 et 205, de façon à isoler électriquement les vias métalliques VR et VB de la LED LG.

Pour réaliser ce retrait partiel de la couche 207, une couche de résine de protection peut d'abord être déposée sur toute la surface supérieure de la structure, la couche de résine s'étendant sur la face supérieure de la couche diélectrique 115 et comblant les tranchées 201 et les ouvertures 203 et 205. La résine peut être ensuite partiellement retirée dans les tranchées 201, de façon à exposer la partie de la couche 207 que l'on souhaite éliminer. Les parties exposées de la couche 207 peuvent ensuite être retirées par gravure. On notera que la partie supérieure de la couche diélectrique 207 peut être retirée, en vue de dessus, sur toute la périphérie de chaque LED LG comme représenté sur la figure 1B, ou, à titre de variante, sur une partie seulement de la périphérie de chaque LED LG (par exemple uniquement en vis-à-vis de la zone d'interruption de la région diélectrique 154 du pixel).

La figure 2F est une vue en coupe illustrant une étape de remplissage des tranchées 201 et des ouvertures 203 et 205 par du métal, de façon à former une portion inférieure des murs métalliques 150, ainsi que les vias métallique VR et une portion inférieure des vias métalliques VB. Le remplissage est par exemple réalisé par un procédé de type damascène. A l'issue de cette étape, le métal déposé dans les tranchées 201 et dans les ouvertures 203 et 205 affleure au niveau de la face supérieure de la couche diélectrique 115. Dans chaque pixel, la portion inférieure du mur métallique périphérique 150 est en contact avec au moins une partie des flancs de la couche de cathode 109 de la LED LG, au niveau de la portion de couche diélectrique retirée à l'étape de la figure 2E. A titre d'exemple, le métal déposé à cette étape comprend du cuivre, de l'aluminium, ou du tungstène, ou un empilement de plusieurs de ces matériaux.

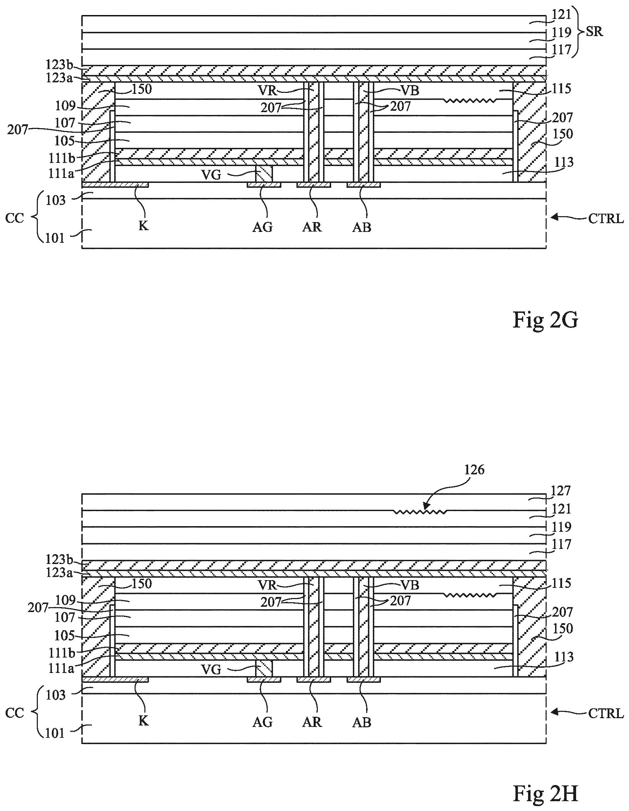

La figure 2G est une vue en coupe illustrant une étape de report d'un deuxième empilement actif de LED SR sur la face supérieure de la structure obtenue à l'issue des étapes des figures 2A à 2F.

L'empilement SR est constitué par les couches 117, 119 et 121 qui, à ce stade, s'étendent chacune de façon continue sur toute la surface supérieure du dispositif. L'empilement SR est par exemple formé par épitaxie sur une face d'un substrat de croissance, non représenté. Plus particulièrement, la couche 121, puis la couche 119, puis la couche 117 peuvent être successivement déposées sur le substrat de croissance. Une ou plusieurs couches tampon, non représentées, peuvent faire interface entre le substrat de croissance et la couche 121. La couche 119 est par exemple déposée sur et en contact avec la face de la couche 121 opposée au substrat de croissance. La couche 117 peut être déposée sur et en contact avec la face de la couche 119 opposée au substrat de croissance.

Préalablement au report, une couche métallique 123a peut être déposée sur et en contact avec la face supérieure de la structure obtenue à l'issue des étapes des figures 2A à 2F. La couche 123a s'étend par exemple de façon continue sur toute la surface supérieure de la structure, et en particulier sur la face supérieure de la couche diélectrique 115 et sur la face supérieure des portions inférieures des murs métalliques 150 et des vias métalliques VB, ainsi que sur la face supérieure des vias métalliques VR. De plus, une couche métallique 123b peut être déposée sur et en contact avec la face de la couche 117 opposée au substrat de croissance de l'empilement SR. La couche 123b s'étend par exemple de façon continue sur toute la surface de l'empilement SR opposée au substrat de croissance.

L'ensemble comprenant le substrat de croissance, l'empilement SR et la couche métallique 123b peut ensuite être reporté sur la face supérieure de la structure obtenue à l'issue des étapes des figures 2A à 2G, par collage direct de la face de la couche métallique 123b opposée au substrat de croissance sur la face de la couche métallique 123a opposée au substrat semiconducteur 101.

Le substrat de croissance de l'empilement SR peut ensuite être retiré, par exemple par un procédé de retrait chimique. La ou les éventuelles couches tampon présentes sur la face supérieure de la couche 121 peuvent en outre être retirées de façon à libérer l'accès à la face supérieure de la couche 121.

Dans cet exemple, les couches métalliques 123a et 123b correspondent, une fois assemblées, à la couche 123 de la structure des figures 1A et 1B.

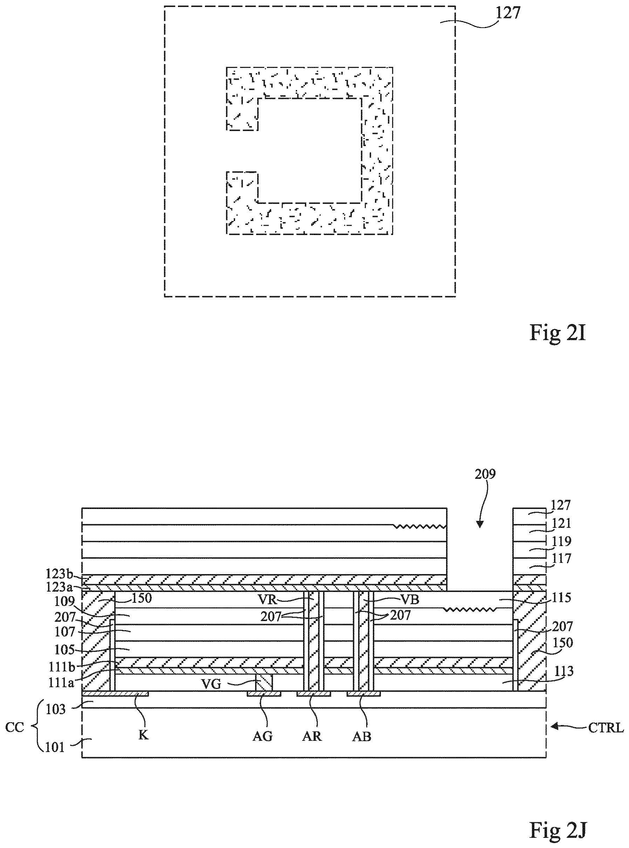

Les figures 2H et 2I sont respectivement une vue en coupe et une vue de dessus illustrant une étape de formation, sur la face supérieure de la couche 121, de nanostructurations 126 formant par exemple des cristaux photoniques, visant à favoriser l'extraction des photons générés par les LED LR. A titre d'exemple, les nanostructurations sont formés uniquement dans la partie périphérique de chaque LED LR destinée à être revêtue par la région diélectrique 158 du pixel correspondant. A titre de variante, les nanostructurations peuvent être formés sur toute la surface supérieure de la couche 121, à l'exception des régions destinées à être gravées lors d'étapes ultérieures du procédé.

Les figures 2H et 2I illustrent en outre une étape ultérieure de dépôt d'une couche diélectrique de protection 127, par exemple une couche de nitrure de silicium, sur et en contact avec la face supérieure de la couche 121. La couche 127 s'étend par exemple de façon continue sur toute la surface supérieure de la couche 121. La couche 127 sert notamment de couche d'encapsulation des nanostructurations, et peut en outre servir de couche de masque dur pour la gravure de l'empilement SR.

La figure 2J est une vue en coupe illustrant une première étape de lithographie et gravure de l'empilement actif de LED SR. Lors de cette étape, dans chaque pixel, une ouverture 209 est formée à partir de la face supérieure de la structure. L'ouverture 209 s'étend verticalement depuis la face supérieure de la couche diélectrique 127 jusqu'à la face supérieure de la couche diélectrique 115. L'ouverture 209 délimite latéralement une partie de la périphérie de la LED LR du pixel. L'ouverture 209 est destinée à recevoir la région diélectrique 154 du pixel. En vue de dessus, l'ouverture 209 a sensiblement la même forme en anneau ouvert que la future région diélectrique 154 du pixel. Autrement dit, à cette étape, l'empilement SR n'est pas gravé en vis-à-vis de la zone 155 (figure 1B) d'interruption de la région diélectrique périphérique 154 du pixel.

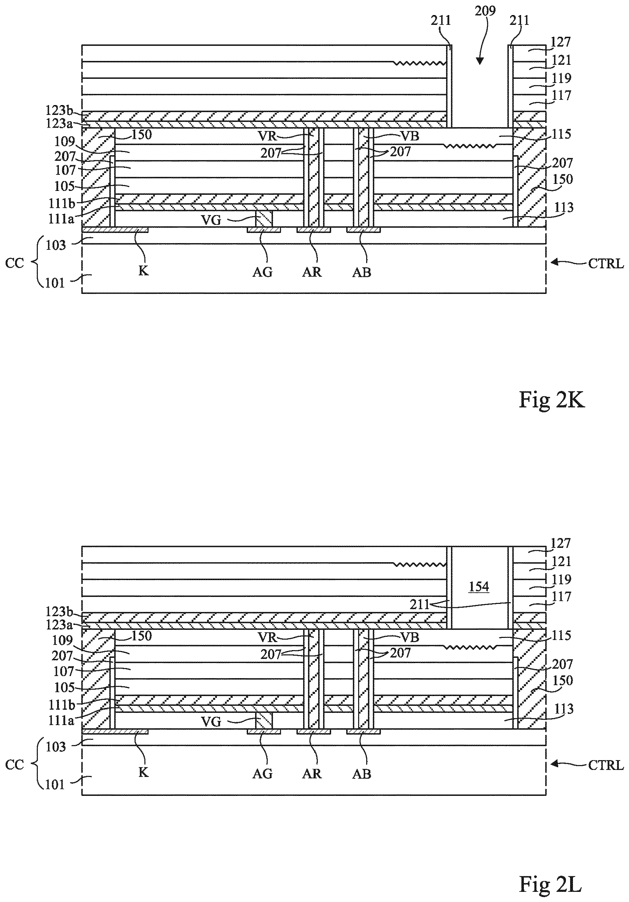

La figure 2K est une vue en coupe illustrant une étape de dépôt d'une mince couche diélectrique 211, par exemple une couche d'oxyde ou de nitrure, sur les parois latérales des ouvertures 209. L'épaisseur de la couche 211 est par exemple inférieure à 200 nm, par exemple de l'ordre de 50 nm. La couche 211 peut être déposée par un procédé de dépôt conforme, par exemple par dépôt ALD. A titre d'exemple, la couche 211 est d'abord déposée de façon continue sur toute la surface de la structure, puis retirée au fond des ouvertures 209 et sur la face supérieure de la couche diélectrique 127 par un procédé de gravure anisotrope verticale. La portion de la couche 211 de la figure 2K revêtant les flancs de la LED LG correspond à la partie de la couche diélectrique 156 de la figure 1B située, en vue de dessus, en dehors de la zone d'interruption de la région diélectrique 154 du pixel.

La figure 2L est une vue en coupe illustrant une étape de remplissage des ouvertures 209 par un matériau diélectrique, par exemple de l'oxyde et/ou du nitrure, pour former la région diélectrique 154 de chaque pixel. A titre d'exemple, une épaisseur de diélectrique supérieure à la hauteur des ouvertures 209 peut d'abord être déposée, puis une étape de planarisation de la face supérieure de la structure peut être mise en oeuvre, par exemple par CMP, de façon que les régions diélectriques 154 affleurent au niveau de la face supérieure de la couche diélectrique 127.

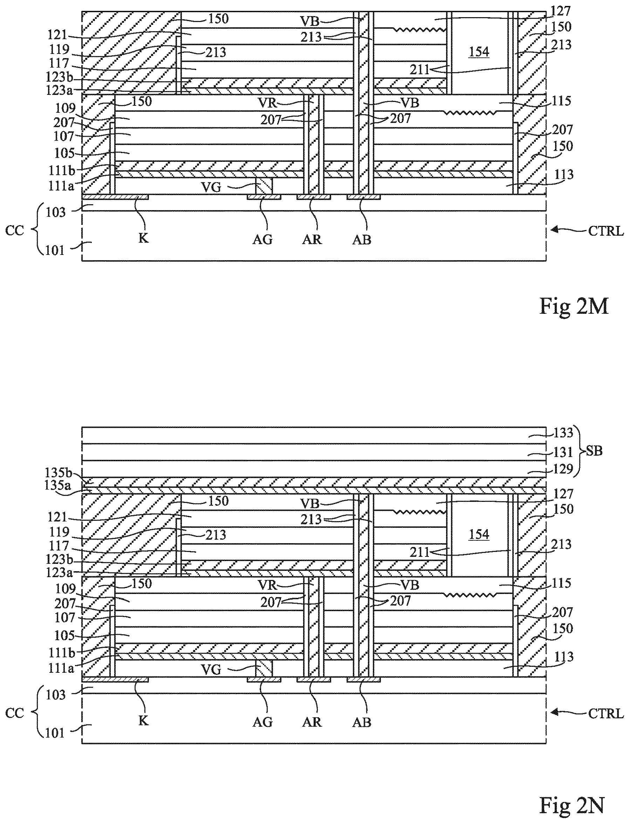

La figures 2M illustre la structure obtenue à l'issue d'étapes similaires aux étapes décrites en relation avec les figures 2D à 2F, mais appliquées à l'empilement SR.

En particulier, une étape de lithographie et gravure de l'empilement actif de LED SR est mise en oeuvre pour former des tranchées destinées à recevoir une portion intermédiaire des murs métalliques périphériques 150. Les tranchées formées à cette étape s'étendent verticalement depuis la face supérieure de la couche diélectrique 127 jusqu'à la face supérieure de la portion inférieure du mur métallique périphérique 150. En vue de dessus, les tranchées s'étendent sensiblement selon le même motif que les tranchées 201 formées à l'étape de la figure 2D. Dans chaque pixel, une portion de tranchée s'étendant, en vue de dessus, de la périphérie vers l'intérieur du pixel, est en outre formée en vis-à-vis de la zone d'interruption de la région diélectrique 154 du pixel. Cette portion de tranchée est destinée à recevoir l'excroissance du mur métallique 150 en contact avec le flanc de la LED LR. Lors de cette étape de lithographie et gravure, on vient en outre former, dans chaque pixel, en vis-à-vis du plot de connexion d'anode AB du pixel, une ouverture débouchant sur la face supérieure de la portion inférieure du via métallique VB formée à l'étape de la figure 2F, cette ouverture étant destinée à recevoir une portion supérieure du via métallique VB.

On vient ensuite déposer une mince couche diélectrique 213 sur les parois latérales des tranchées et ouvertures formées à l'étape précédente. L'épaisseur de la couche 213 est par exemple inférieure à 200 nm, par exemple de l'ordre de 50 nm. La couche 213 peut être une couche d'oxyde ou de nitrure déposée par un procédé de dépôt conforme, par exemple par PECVD (de l'anglais "Plasma Enhanced Chemical Vapor Deposition" - dépôt chimique en phase vapeur assisté par plasma). A titre d'exemple, la couche 213 est d'abord déposée de façon continue sur toute la surface de la structure, puis retirée au fond des tranchées et des ouvertures et sur la face supérieure de la couche diélectrique 127, par un procédé de gravure anisotrope verticale. Au niveau de la zone d'interruption de la région diélectrique 154, la couche 213 vient en contact avec les flancs de la LED LR. A cet endroit, la couche 213 correspond à la couche diélectrique 156 de la figure 1B. Dans l'ouverture destinée à recevoir la portion supérieure du via VB, la couche 213 correspond à une partie supérieure de la couche diélectrique 137 de la figure 1B.

Une étape similaire à l'étape de la figure 2E est ensuite mise en oeuvre, au cours de laquelle on retire une partie supérieure de la couche diélectrique 213 sur les flancs de la couche diélectrique 127 et sur une partie supérieure des flancs de la couche de cathode 121 de chaque LED LR, dans la zone d'interruption de la région diélectrique 154, de façon à permettre la reprise d'un contact électrique sur la couche 121, via les murs métalliques 150. La couche 213 est en revanche conservée sur les flancs de la couche active 119 et des couches sous-jacentes, de façon à isoler électriquement les couches 123, 117 et 119 des murs métalliques 150. La couche 213 est de plus conservée sur toute la hauteur de l'ouverture destinée à recevoir la portion supérieure du via métallique VB, de façon à isoler électriquement le via VB de la LED LR.

La figure 2M illustre de plus une étape similaire à l'étape de la figure 2F, de remplissage des tranchées et ouvertures par du métal, de façon à former une portion intermédiaire des murs métalliques 150, ainsi qu'une portion supérieure des vias métalliques VB. A l'issue de cette étape, le métal déposé dans les tranchées et ouvertures affleure au niveau de la face supérieure de la couche diélectrique 127 et de la région diélectrique 154. Dans chaque pixel, la portion intermédiaire du mur métallique 150 est en contact avec une partie des flancs de la couche de cathode 121 de la LED LR, au niveau de la zone d'interruption de la région diélectrique 154 du pixel. A titre d'exemple, le métal déposé à cette étape comprend du titane, de l'aluminium ou du cuivre, du germanium, du nickel, du platine, ou un empilement d'un ou plusieurs de ces matériaux.

La figure 2N est une vue en coupe illustrant une étape de report d'un troisième empilement actif de LED SB sur la face supérieure de la structure obtenue à l'issue des étapes des figures 2A à 2M. L'empilement SB est constitué par les couches 129, 131 et 133 qui, à ce stade, s'étendent chacune de façon continue sur toute la surface supérieure du dispositif. L'empilement SB est par exemple formé par épitaxie sur une face d'un substrat de croissance, par exemple en saphir, non représenté. Plus particulièrement, la couche 133, puis la couche 131, puis la couche 129 peuvent être successivement déposées sur le substrat de croissance. Une ou plusieurs couches tampon, non représentées, peuvent faire interface entre le substrat de croissance et la couche 133. La couche 131 est par exemple déposée sur et en contact avec la face de la couche 133 opposée au substrat de croissance. La couche 129 peut être déposée sur et en contact avec la face de la couche 131 opposée au substrat de croissance.

Préalablement au report, une couche métallique 135a peut être déposée sur et en contact avec la face supérieure de la structure obtenue à l'issue des étapes des figures 2A à 2M. La couche 135a s'étend par exemple de façon continue sur toute la surface supérieure de la structure. De plus, une couche métallique 135b peut être déposée sur et en contact avec la face de la couche 129 opposée au substrat de croissance de l'empilement SB. La couche 135b s'étend par exemple de façon continue sur toute la surface de l'empilement SB opposée au substrat de croissance.

L'ensemble comprenant le substrat de croissance, l'empilement SB et la couche métallique 135b peuvent ensuite être reportés sur la face supérieure de la structure obtenue à l'issue des étapes des figures 2A à 2M, par collage direct ou thermocompression de la face de la couche métallique 135b opposée au substrat de croissance sur la face de la couche métallique 135a opposée au substrat semiconducteur 101.

Le substrat de croissance de l'empilement SB peut ensuite être retiré, par exemple par un procédé de type LLO. La ou les éventuelles couches tampon présentes sur la face supérieure de la couche 133 peuvent en outre être retirées de façon à libérer l'accès à la face supérieure de la couche 133.

Dans cet exemple, les couches métalliques 135a et 135b correspondent, une fois assemblées, à la couche 135 de la structure des figures 1A et 1B.

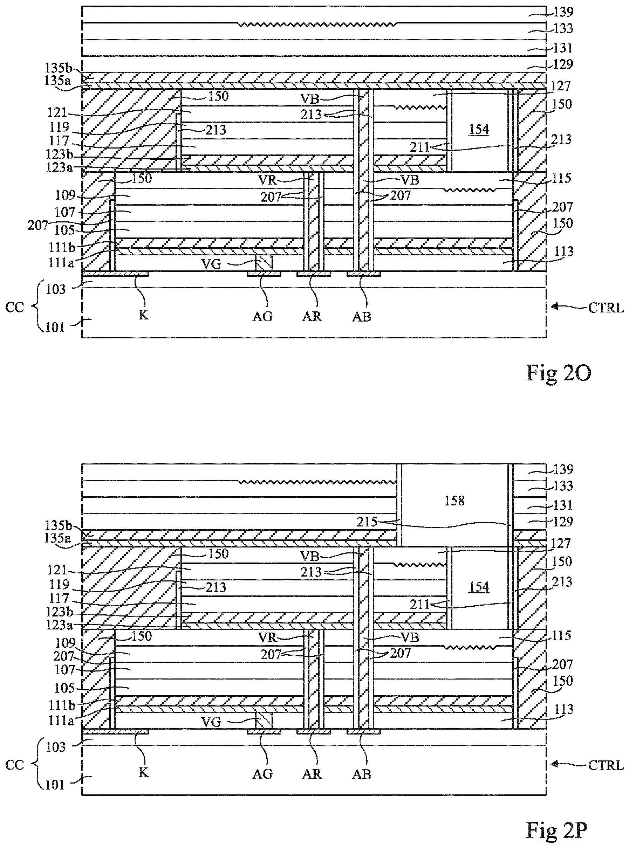

La figure 2O est une vue en coupe illustrant une étape de formation, sur la face supérieure de la couche 133, de nano-structurations, par exemple des cristaux photoniques, visant à favoriser l'extraction des photons générés par les LED LB. A titre d'exemple, les nanostructurations sont formés, dans chaque pixel, sur toute la surface de la LED LB du pixel. De préférence, les nanostructurations ne sont pas formés sur les régions de la couche 133 destinées à être gravées lors d'étapes ultérieures du procédé.

La figure 2O illustre en outre une étape ultérieure de dépôt d'une couche diélectrique de protection 139, par exemple une couche d'oxyde de silicium ou de nitrure de silicium, sur et en contact avec la face supérieure de la couche 133. La couche 139 s'étend par exemple de façon continue sur toute la surface supérieure de la couche 133. La couche 139 sert notamment de couche d'encapsulation des nanostructurations, et peut en outre servir de couche de masque dur pour la gravure de l'empilement SB.

La figure 2P est une vue en coupe illustrant la structure obtenue à l'issue d'étapes similaires aux étapes des figures 2J à 2L, mais appliquées à l'empilement SB.

Plus particulièrement, après les étapes de la figure 2O, une première étape de lithographie et gravure de l'empilement actif de LED SB est mise en oeuvre. Lors de cette étape, dans chaque pixel, une ouverture est formée à partir de la face supérieure de la structure, cette ouverture s'étendant verticalement depuis la face supérieure de la couche diélectrique 139 jusqu'à la face supérieure de la couche diélectrique 127, et délimitant latéralement une partie de la périphérie de la LED LB du pixel. L'ouverture formée à cette étape est destinée à recevoir la région diélectrique 158 du pixel. En vue de dessus, cette ouverture a sensiblement la même forme en anneau ouvert que la future région diélectrique 158 du pixel. Autrement dit, à cette étape, l'empilement SB n'est pas gravé en vis-à-vis de la zone d'interruption de la région diélectrique périphérique 158 du pixel.

Une mince couche diélectrique 215, par exemple une couche d'oxyde ou de nitrure, est ensuite déposée sur les parois latérales de l'ouverture. L'épaisseur de la couche 215 est par exemple inférieure à 200 nm, par exemple de l'ordre de 50 nm. La couche 215 peut être déposée par un procédé de dépôt conforme, par exemple par dépôt ALD. A titre d'exemple, la couche 215 est d'abord déposée de façon continue sur toute la surface de la structure, puis retirée au fond des ouvertures et sur la face supérieure de la couche diélectrique 139 par un procédé de gravure anisotrope verticale. La portion de la couche 215 revêtant les flancs de la LED LB correspond à la partie de la couche diélectrique 160 de la figure 1B située, en vue de dessus, en dehors de la zone d'interruption de la région diélectrique 158 du pixel.

Les ouvertures sont ensuite remplies par un matériau diélectrique, par exemple de l'oxyde et/ou du nitrure, pour former la région diélectrique 158 de chaque pixel. A titre d'exemple, une épaisseur de diélectrique supérieure à la hauteur des ouvertures peut d'abord être déposée, puis une étape de planarisation de la face supérieure de la structure peut être mise en oeuvre, par exemple par CMP, de façon à conserver uniquement des régions diélectriques 158 affleurant au niveau de la face supérieure de la couche diélectrique 139.

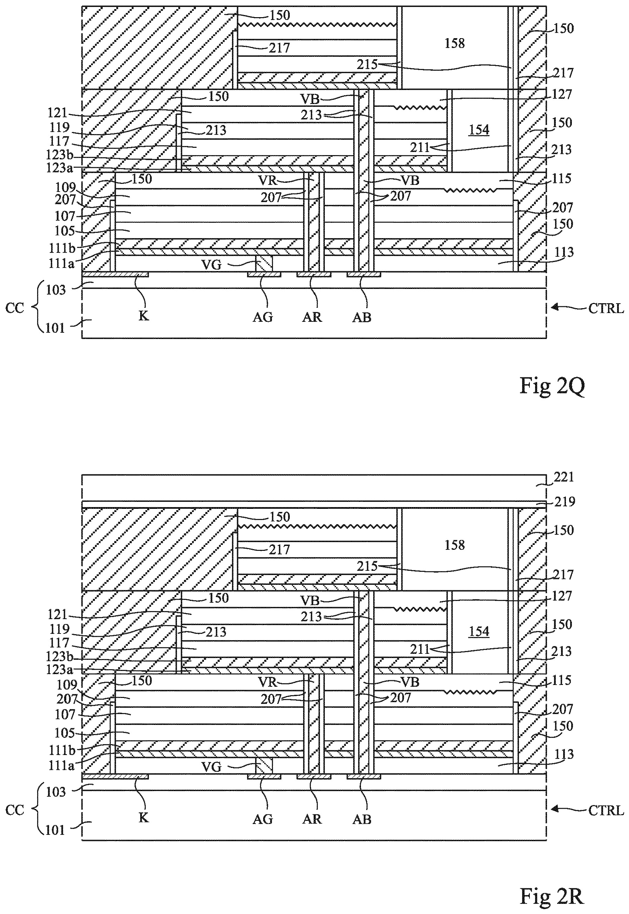

La figure 2Q est une vue en coupe illustrant la structure obtenue à l'issue d'étapes similaires aux étapes décrites en relation avec la figure 2M, mais appliquées à l'empilement SB.

En particulier, une étape de lithographie et gravure de l'empilement actif de LED SB est mise en oeuvre pour former des tranchées destinées à recevoir une portion supérieure des murs métalliques périphériques 150. Les tranchées formées à cette étape s'étendent verticalement depuis la face supérieure de la couche diélectrique 139 jusqu'à la face supérieure de la portion intermédiaire du mur métallique périphérique 150. En vue de dessus, les tranchées s'étendent sensiblement selon le même motif que les tranchées 201 formées à l'étape de la figure 2D. Dans chaque pixel, une portion de tranchée s'étendant, en vue de dessus, de la périphérie vers l'intérieur du pixel, est en outre formée en vis-à-vis de la zone d'interruption de la région diélectrique 158 du pixel. Cette portion de tranchée est destinée à recevoir l'excroissance du mur métallique 150 en contact avec le flanc de la LED LB.

On vient ensuite déposer une mince couche diélectrique 217 sur les parois latérales des tranchées. L'épaisseur de la couche 217 est par exemple inférieure à 200 nm, par exemple de l'ordre de 50 nm. La couche 217 peut être une couche d'oxyde ou de nitrure déposée par un procédé de dépôt conforme, par exemple par ALD. A titre d'exemple, la couche 217 est d'abord déposée de façon continue sur toute la surface de la structure, puis retirée au fond des tranchées et des ouvertures et sur la face supérieure de la couche diélectrique 139, par un procédé de gravure anisotrope verticale. Au niveau de la zone d'interruption de la région diélectrique 158, la couche 217 vient en contact avec les flancs de la LED LB. A cet endroit, la couche 217 correspond à la couche diélectrique 160 de la figure 1B.

Une étape similaire à l'étape de la figure 2E est ensuite mise en oeuvre, au cours de laquelle on retire une partie supérieure de la couche diélectrique 217 sur les flancs de la couche diélectrique 139 et sur une partie supérieure des flancs de la couche de cathode 133 de chaque LED LB, dans la zone d'interruption de la région diélectrique 158, de façon à permettre la reprise d'un contact électrique sur la couche 133, via les murs métalliques 150. La couche 217 est en revanche conservée sur les flancs de la couche active 131 et des couches sous-jacentes, de façon à isoler électriquement les couches 135, 129 et 131 des murs métalliques 150.

La figure 2Q illustre de plus une étape similaire à l'étape de la figure 2F, de remplissage des tranchées par du métal, de façon à former une portion supérieure des murs métalliques 150. A l'issue de cette étape, le métal déposé dans les tranchées affleure au niveau de la face supérieure de la couche diélectrique 139 et de la région diélectrique 158. Le métal déposé dans les tranchées est en contact avec une partie des flancs de la couche de cathode 133 de chaque LED LB, au niveau de la zone d'interruption de la région diélectrique 158. Le métal déposé à cette étape comprend par exemple du cuivre, de l'aluminium ou du tungstène, ou un empilement de plusieurs de ces matériaux.

La figure 2R est une vue en coupe illustrant une étape de dépôt d'une ou plusieurs couches diélectriques de passivation sur la face supérieure de la structure obtenue à l'issue des étapes des figures 2A à 2Q. Dans l'exemple représenté, deux couches diélectriques 219 et 221 sont successivement déposées sur la face supérieure de la structure. Les couches 219 et 221 sont par exemple respectivement une couche de nitrure de silicium et une couche d'oxyde de silicium. L'épaisseur de la couche 219 est par exemple de l'ordre de 40 nm. L'épaisseur de la couche 221 est par exemple de l'ordre de 600 nm. A titre d'exemple, chacune des couches 219 et 221 s'étend de façon continue sur toute la face supérieure du dispositif. La couche 219 peut être déposée sur et en contact avec la face supérieure de la structure de la figure 2Q, c'est-à-dire sur et en contact avec la face supérieure des murs métalliques 150, de la région diélectrique 158, et de la couche diélectrique 139. La couche 221 est par exemple déposée sur et en contact avec la face supérieure de la couche 219.

Divers modes de réalisation et variantes ont été décrits. La personne du métier comprendra que certaines caractéristiques de ces divers modes de réalisation et variantes pourraient être combinées, et d'autres variantes apparaîtront à l'homme de l'art. En particulier, bien que l'on ait décrit ci-dessus des exemples de réalisation de pixels comportant chacun trois LED adaptées à émettre respectivement dans trois gammes de longueurs d'ondes différentes, la personne du métier saura adapter les modes décrits à la réalisation de pixels comportant chacun un nombre de LED de couleurs distinctes différent de trois, par exemple égal à deux ou supérieur à trois.

De plus, tous les types de conductivités des régions semiconductrices des structures décrites peuvent être inversés. Dans ce cas, les régions d'anode des structures décrites deviennent des régions de cathode, et inversement.

En outre, dans les exemples décrits ci-dessus, chaque LED comprend des nanostructurations, par exemple des cristaux photoniques sur la face supérieure de sa couche de cathode. A titre de variante, les nanostructurations peuvent être omises sur au moins une partie ou sur la totalité des LED.

Par ailleurs, bien que l'on ait représenté sur les figures des LED de forme générale carrée ou rectangulaire (en vue de dessus), les modes de réalisation décrits ne se limitent pas à ce cas particulier. A titre de variante, les LED peuvent avoir, en vue de dessus, d'autre formes que celles représentées, par exemple des formues circulaire, elliptiques, etc.

## Revendications

1. Dispositif d'affichage émissif à LED, comportant une pluralité de pixels comprenant chacun :
- une cellule élémentaire de contrôle (CTRL) formée dans et sur un substrat semiconducteur (101) ;
- une première LED (LG) adaptée à émettre dans une première gamme de longueurs d'ondes, disposée sur la face supérieure de la cellule élémentaire de contrôle et ayant une première région de conduction connectée à un premier plot de connexion (AG) de la cellule élémentaire de contrôle ; et
- une deuxième LED (LR) adaptée à émettre dans une deuxième gamme de longueurs d'ondes, de surface inférieure à celle de la première LED, disposée sur la face supérieure de la première LED en vis-à-vis d'une région centrale de la première LED, et ayant une première région de conduction connectée à un deuxième plot de connexion (AR) de la cellule élémentaire de contrôle par l'intermédiaire d'un premier via conducteur (VR) traversant la première LED, dans lequel chaque pixel comprend un mur périphérique métallique (150) entourant entièrement le pixel et s'étendant sur toute la hauteur des LED du pixel, et dans lequel, dans chaque pixel, chaque LED a une deuxième région de conduction connectée au mur périphérique métallique (150) du pixel.

2. Dispositif selon la revendication 1, dans lequel chaque pixel comprend en outre une troisième LED (LB) adaptée à émettre dans une troisième gamme de longueurs d'ondes, de surface inférieure à celle de la deuxième LED, disposée sur la face supérieure de la deuxième LED en vis-à-vis d'une région centrale de la deuxième LED, et ayant une première région de conduction connectée à un troisième plot de connexion (AB) de la cellule élémentaire de contrôle par l'intermédiaire d'un deuxième via conducteur (VB) traversant les première et deuxième LED.

3. Dispositif selon la revendication 1 ou 2, dans lequel le mur périphérique (150) est réfléchissant pour la lumière émise par chaque LED, et forme un miroir guidant la lumière émise par chaque LED.

4. Dispositif selon l'une quelconque des revendications 1 à 3, dans lequel chaque LED comprend un empilement comportant, dans l'ordre en partant de la face supérieure du substrat semiconducteur (101), une première couche semiconductrice (105, 117, 129) dopée d'un premier type de conductivité, formant la première région de conduction de la LED, une couche active (107, 119, 131), et une deuxième couche semiconductrice (109, 121, 133) dopée du second type de conductivité, formant la deuxième région de conduction de la LED.

5. Dispositif selon la revendication 4, dans lequel, dans chaque pixel, chaque LED est connectée au mur périphérique métallique (150) du pixel par un flanc de sa deuxième couche semiconductrice (109, 121, 133).

6. Dispositif selon la revendication 4 ou 5, dans lequel, dans chaque pixel, chaque LED a sa première couche semiconductrice (105, 117, 129) en contact, par sa face inférieure, avec une couche métallique (111, 123, 135) s'étendant sous toute la surface de la LED.

7. Dispositif selon la revendication 6, dans lequel, pour chaque LED, la couche métallique (111, 123, 135) en contact avec la face inférieure de la première couche semiconductrice (105, 117, 129) de la LED est une couche réfléchissante formant un miroir guidant la lumière émise par chaque LED.

8. Dispositif selon l'une quelconque des revendications 1 à 7, dans lequel les premières (105, 117, 129) et deuxièmes (109, 121, 133) régions de conduction des LED sont respectivement des régions d'anode et des régions de cathode.

9. Dispositif selon l'une quelconque des revendications 1 à 8, dans lequel chaque pixel comprend une région diélectrique transparente (154) recouvrant une partie périphérique de la première LED (LG) non recouverte par la deuxième LED (LR) .

10. Dispositif selon l'une quelconque des revendications 1 à 9, dans lequel la première LED (LG) présente, dans une partie périphérique de la première LED (LG) non recouverte par la deuxième LED (LR), des nanostructurations adaptée à favoriser l'extraction de la lumière émise par la première LED (LG).

11. Procédé de fabrication d'un dispositif d'affichage émissif à LED comportant une pluralité de pixels comprenant chacun :
- une cellule élémentaire de contrôle (CTRL) formée dans et sur un substrat semiconducteur (101) ;
- une première LED (LG) adaptée à émettre dans une première gamme de longueurs d'ondes, disposée sur la face supérieure de la cellule élémentaire de contrôle et ayant une première région de conduction connectée à un premier plot de connexion (AG) de la cellule élémentaire de contrôle ; et
- une deuxième LED (LR) adaptée à émettre dans une deuxième gamme de longueurs d'ondes, de surface inférieure à celle de la première LED, disposée sur la face supérieure de la première LED en vis-à-vis d'une région centrale de la première LED, et ayant une première région de conduction connectée à un deuxième plot de connexion (AR) de la cellule élémentaire de contrôle par l'intermédiaire d'un premier via conducteur (VR) traversant la première LED, dans lequel chaque pixel comprend un mur périphérique métallique (150) entourant entièrement le pixel et s'étendant sur toute la hauteur des LED du pixel,
et dans lequel, dans chaque pixel, chaque LED a une deuxième région de conduction connectée au mur périphérique métallique (150) du pixel,
le procédé comportant les étapes successives suivantes :
- rapporter un premier empilement actif de LED (SG) sur la face supérieure d'un circuit intégré de contrôle (CC) comprenant les cellules élémentaires de contrôle (CTRL) du dispositif, de façon que le premier empilement actif de LED (SG) s'étende de façon continue sur toute la surface du circuit intégré de contrôle (CC) ;
- former dans le premier empilement actif de LED (SG) des tranchées délimitant latéralement les premières LED (LG) du dispositif ;
- rapporter un deuxième empilement actif de LED (SR) sur la face supérieure de l'ensemble comportant le circuit intégré (CC) et les premières LED (LG), de façon que le deuxième empilement actif de LED (SR) s'étende de façon continue sur toute la surface du circuit intégré de contrôle (CC) ; et
- former dans le deuxième empilement actif de LED (SR) des tranchées délimitant latéralement les deuxièmes LED (LR) du dispositif.

## Patentansprüche

1. Emissive Anzeigevorrichtung mit LEDs, die eine Vielzahl von Pixeln umfasst, von denen jedes Folgendes aufweist:
- eine elementare Steuerzelle (CTRL), die innerhalb und auf der Oberseite eines Halbleitersubstrats (101) ausgebildet ist;
- eine erste LED (LG), die in der Lage ist, in einem ersten Wellenlängenbereich zu emittieren, und die auf der Oberseite der elementaren Steuerzelle angeordnet ist und einen ersten leitenden Bereich aufweist, der mit einer ersten Anschlussfläche (AG) der elementaren Steuerzelle verbunden ist; und
- eine zweite LED (LR), die in der Lage ist, in einem zweiten Wellenlängenbereich zu emittieren, die eine kleinere Oberfläche als die erste LED hat, die auf der Oberseite der ersten LED gegenüber einem zentralen Bereich der ersten LED angeordnet ist und die einen ersten leitenden Bereich hat, der mit einer zweiten Anschlussfläche (AR) der elementaren Steuerzelle über einen ersten leitenden Durchgang (VR), der durch die erste LED hindurchgeht, verbunden ist,
wobei jedes Pixel eine metallische Umfangswand (150) aufweist, die das Pixel vollständig umgibt und sich über die gesamte Höhe der LEDs des Pixels erstreckt, und wobei in jedem Pixel jede LED einen zweiten leitenden Bereich aufweist, der mit der metallischen Umfangswand (150) des Pixels verbunden ist.

2. Vorrichtung nach Anspruch 1, wobei jedes Pixel ferner eine dritte LED (LB) aufweist, die in der Lage ist, in einem dritten Wellenlängenbereich zu emittieren, die eine kleinere Oberfläche als die zweite LED hat, die auf der Oberseite der zweiten LED gegenüber einem zentralen Bereich der zweiten LED angeordnet ist und die einen ersten leitenden Bereich aufweist, der mit einer dritten Anschlussfläche (AB) der elementaren Steuerzelle über einen zweiten leitenden Durchgang (VB), der durch die erste und die zweite LED hindurchgeht, verbunden ist.

3. Vorrichtung nach Anspruch 1, wobei die Umfangswand (150) für das von jeder LED emittierte Licht reflektierend ist und einen Spiegel bildet, der das von jeder LED emittierte Licht leitet.

4. Vorrichtung nach Anspruch 1, wobei jede LED einen Stapel aufweist, der in der Reihenfolge von der oberen Oberfläche des Halbleitersubstrats (101) Folgendes ausweist: eine erste dotierte Halbleiterschicht (105, 117, 129) eines ersten Leitfähigkeitstyps, die den ersten leitenden Bereich der LED bildet, eine aktive Schicht (107, 119, 131) und eine zweite dotierte Halbleiterschicht (109, 121, 133) des zweiten Leitfähigkeitstyps aufweist, die den zweiten leitenden Bereich der LED bildet.

5. Vorrichtung nach Anspruch 4, wobei in jedem Pixel jede LED über eine Seite ihrer zweiten Halbleiterschicht (109, 121, 133) mit der metallischen Umfangswand (150) des Pixels verbunden ist.

6. Vorrichtung nach Anspruch 4, wobei in jedem Pixel die erste Halbleiterschicht (105, 117, 129) jeder LED über ihre Unterseite mit einer Metallschicht (111, 123, 135) in Kontakt steht, die sich unter der gesamten Oberfläche der LED erstreckt.

7. Vorrichtung nach Anspruch 6, wobei für jede LED die Metallschicht (111, 123, 135), die in Kontakt mit der Unterseite der ersten Halbleiterschicht (105, 117, 129) der LED steht, eine reflektierende Schicht ist, die einen Spiegel bildet, der das von jeder LED emittierte Licht leitet.

8. Vorrichtung nach Anspruch 1, wobei der ersten (105, 117, 129) und zweiten (109, 121, 133) leitenden Bereiche der LEDs Anodenbereiche bzw. Kathodenbereiche sind.

9. Vorrichtung nach Anspruch 1, wobei jedes Pixel einen transparenten dielektrischen Bereich (154) aufweist, der einen Umfangsabschnitt der ersten LED (LG) abdeckt, der nicht von der zweiten LED (LR) abgedeckt ist.

10. Vorrichtung nach Anspruch 1, wobei die erste LED (LG) in einem Randbereich der ersten LED (LG), der nicht von der zweiten LED (LR) abgedeckt ist, Nanostrukturen aufweist, die in der Lage sind, die Extraktion des von der ersten LED (LG) emittierten Lichts zu begünstigen.

11. Verfahren zur Herstellung der emittierenden Anzeigevorrichtung mit LEDs, die eine Vielzahl von Pixeln umfasst, von denen jedes Folgendes aufweist:
- eine elementare Steuerzelle (CTRL), die im Inneren und auf der Oberseite eines Halbleitersubstrats (101) ausgebildet ist;
- eine erste LED (LG), die in der Lage ist, in einem ersten Wellenlängenbereich zu emittieren, und die auf der Oberseite der elementaren Steuerzelle angeordnet ist und einen ersten leitenden Bereich aufweist, der mit einer ersten Anschlussfläche (AG) der elementaren Steuerzelle verbunden ist; und
- eine zweite LED (LR), die in der Lage ist, in einem zweiten Wellenlängenbereich zu emittieren, die eine kleinere Oberfläche als die erste LED hat, die auf der Oberseite der ersten LED gegenüber einem zentralen Bereich der ersten LED angeordnet ist und die einen ersten leitenden Bereich hat, der mit einer zweiten Anschlussfläche (AR) der elementaren Steuerzelle über einen ersten leitenden Durchgang (VR) verbunden ist, der durch die erste LED hindurchgeht,
wobei jedes Pixel eine metallische Umfangswand (150) aufweist, die das Pixel vollständig umgibt und sich über die gesamte Höhe der LEDs des Pixels erstreckt, und wobei in jedem Pixel jede LED einen zweiten leitenden Bereich aufweist, der mit der metallischen Umfangswand (150) des Pixels verbunden ist,
wobei das Verfahren die folgenden aufeinanderfolgenden Schritte aufweist:
- Anordnen eines ersten aktiven LED-Stapels (SG) auf der Oberseite einer integrierten Steuerschaltung (CC), die die elementaren Steuerzellen (CTRL) der Vorrichtung aufweist, so dass sich der erste aktive LED-Stapel (SG) kontinuierlich über die gesamte Fläche der integrierten Steuerschaltung (CC) erstreckt;
- Ausbilden von Gräben in dem ersten aktiven LED-Stapel (SG), die die ersten LEDs (LG) der Vorrichtung seitlich begrenzen;
- Anordnen eines zweiten aktiven LED-Stapels (SR) auf der Oberseite der Anordnung, die die integrierte Steuerschaltung (CC) und die ersten LEDs (LG) aufweist, so dass sich der erste aktive LED-Stapel (SR) kontinuierlich über die gesamte Fläche der integrierten Steuerschaltung (CC) erstreckt; und
- Ausbilden von Gräben in dem zweiten aktiven LED-Stapel (SR), die die zweiten LEDs (LR) der Vorrichtung seitlich begrenzen.

## Claims

1. An emissive display device comprising LEDs, comprising a plurality of pixels, each comprising:
- an elementary control cell (CTRL) formed inside and on top of a semiconductor substrate (101);
- a first LED (LG) capable of emitting in a first wavelength range, arranged on the upper surface of the elementary control cell and having a first conduction region connected to a first connection pad (AG) of the elementary control cell; and
- a second LED (LR) capable of emitting in a second wavelength range, having a surface area smaller than that of the first LED, arranged on the upper surface of the first LED opposite a central region of the first LED, and having a first conduction region connected to a second connection pad (AR) of the elementary control cell via a first conductive via (VR) crossing the first LED,
wherein each pixel comprises a metallic peripheral wall (150) totally surrounding the pixel and extending all along the height of the LEDs of the pixel,
and wherein, in each pixel, each LED has a second conduction region connected to the metallic peripheral wall (150) of the pixel.

2. The device according to claim 1, wherein each pixel further comprises a third LED (LB) capable of emitting in a third wavelength range, having a surface area smaller than that of the second LED, arranged on the upper surface of the second LED opposite a central region of the second LED, and having a first conduction region connected to a third connection pad (AB) of the elementary control cell via a second conductive via (VB) crossing the first and second LEDs.

3. The device according to claim 1, wherein the peripheral wall (150) is reflective for the light emitted by each LED and forms a mirror guiding the light emitted by each LED.

4. The device according to claim 1, wherein each LED comprises a stack comprising, in the order from the upper surface of the semiconductor substrate (101), a first doped semiconductor layer (105, 117, 129) of a first conductivity type, forming the first conduction region of the LED, an active layer (107, 119, 131), and a second doped semiconductor layer (109, 121, 133) of the second conductivity type, forming the second conduction region of the LED.

5. The device according to claim 4, wherein, in each pixel, each LED is connected to the metallic peripheral wall (150) of the pixel by a side of its second semiconductor layer (109, 121, 133).

6. The device according to claim 4, wherein, in each pixel, each LED has its first semiconductor layer (105, 117, 129) in contact, by its lower surface, with a metal layer (111, 123, 135) extending under the entire surface of the LED.

7. The device according to claim 6, wherein for each LED, the metal layer (111, 123, 135) in contact with the lower surface of the first semiconductor layer (105, 117, 129) of the LED is a reflective layer forming a mirror guiding the light emitted by each LED.

8. The device according to claim 1, wherein the first (105, 117, 129) and second (109, 121, 133) conduction regions of the LEDs are respectively anode regions and cathode regions.

9. The device according to claim 1, wherein each pixel comprises a transparent dielectric region (154) covering a peripheral portion of the first LED (LG) which is not covered by the second LED (LR).

10. The device according to claim 1, wherein the first LED (LG) has, in a peripheral portion of the first LED (LG) which is not covered by the second LED (LR), nanostructures capable of favoring the extraction of the light emitted by the first LED (LG).

11. A method of manufacturing the emissive display device comprising LEDs comprising a plurality of pixels, each comprising:
- an elementary control cell (CTRL) formed inside and on top of a semiconductor substrate (101);
- a first LED (LG) capable of emitting in a first wavelength range, arranged on the upper surface of the elementary control cell and having a first conduction region connected to a first connection pad (AG) of the elementary control cell; and
- a second LED (LR) capable of emitting in a second wavelength range, having a surface area smaller than that of the first LED, arranged on the upper surface of the first LED opposite a central region of the first LED, and having a first conduction region connected to a second connection pad (AR) of the elementary control cell via a first conductive via (VR) crossing the first LED,
wherein each pixel comprises a metallic peripheral wall (150) totally surrounding the pixel and extending all along the height of the LEDs of the pixel,
and wherein, in each pixel, each LED has a second conduction region connected to the metallic peripheral wall (150) of the pixel,
the method comprising the successive steps of:
- placing a first active LED stack (SG) on the upper surface of an integrated control circuit (CC) comprising the elementary control cells (CTRL) of the device, so that the first active LED stack (SG) continuously extends all over the surface of the integrated control circuit (CC) ;
- forming in the first active LED stack (SG) trenches laterally delimiting the first LEDs (LG) of the device;
- placing a second active LED stack (SR) on the upper surface of the assembly comprising the integrated control circuit (CC) and the first LEDs (LG), so that the first active LED stack (SR) continuously extends all over the surface of the integrated control circuit (CC); and
- forming in the second active LED stack (SR) trenches laterally delimiting the second LEDs (LR) of the device.
